# EUROPÄISCHE PATENTSCHRIFT

(11) **EP 3 891 011 B1**
(45) Veröffentlichungstag und Bekanntmachung des Hinweises auf die Patenterteilung: **27.09.2023**
(21) Anmeldenummer: 19813816.6
(22) Anmeldetag: 03.12.2019
(51) Int. Cl.: B60L 58/10, B60L 58/12, B60L 58/24

(54) **VERFAHREN ZUM BETREIBEN EINES ELEKTRISCHEN ENERGIESPEICHERS**
METHOD FOR OPERATING AN ELECTRICAL ENERGY STORE
PROCÉDÉ POUR FAIRE FONCTIONNER UN ACCUMULATEUR D'ÉNERGIE ÉLECTRIQUE

(30) Priorität: 05.12.2018 DE 102018220981
(43) Veröffentlichungstag der Anmeldung: 13.10.2021
(73) Patentinhaber: Robert Bosch GmbH, 70442 Stuttgart (DE)
(72) Erfinder: SARFERT, Christel, 70825 Korntal-Muenchingen (DE); BECKER, Jens, 71726 Benningen Am Neckar (DE); KROENER, Christoph, 90574 Rosstal (DE); POEHLER, Joerg, 70825 Korntal-Muenchingen (DE)
(86) Internationale Anmeldenummer: PCT/EP2019/083444
(87) Internationale Veröffentlichungsnummer: WO 2020/115027

(56) Entgegenhaltungen:
- EP-A1- 3 309 892
- CN-A- 105 667 464
- US-A1- 2015 345 962
- US-A1- 2018 194 238

## Beschreibung

### Stand der Technik

Elektrische Energiespeicher, beispielsweise Batterien, wie sie in Elektrofahrzeugen zur Anwendung kommen, umfassen üblicherweise eine Speicherzelle und eine Steuereinheit, die auch als Batteriemanagementsystem (BMS) bezeichnet wird. Für den Betrieb der Batterie ist üblicherweise Kenntnis oder zumindest eine Annahme über diverse Betriebsparameter der Batterie nötig. Beispielsweise bildet der innere Widerstand der Batterie eine Eingangsgröße für diverse Betriebssituationen wie beispielsweise eine Schnellladestrategie oder die Ermittlung eines Ladezustands der Batterie.

Verfahren zum Betreiben eines elektrischen Energiespeichers, bei dem Betriebsparameter wie z. B. der elektrische Innenwiderstand der Batterie durch das BMS abgeschätzt werden, sind vom Markt her bekannt. Hierfür geht das BMS üblicherweise davon aus, dass sich die Batterie wie eine Vergleichsbatterie, zu der umfangreiche Laboruntersuchungen vorliegen, verhält und schätzt entsprechend die Betriebsparameter ab. Üblicherweise wird hierfür das BMS bei Produktion bedatet, wobei eine aktualisierung der Daten oder eine indivisualisierung auf die spezifische Batterie nicht vorgesehen ist. Umfasst die Abschätzung der Betriebsparameter durch das BMS aufwendige Algorithmen, ist hierfür entsprechende Rechenleistung innerhalb des BMS nötig.

### Offenbarung der Erfindung

Das erfindungsgemäße Verfahren zum Betreiben eines elektrischen Energiespeichers, der eine Speicherzelle zum Speichern von elektrischer Energie und eine Steuereinheit umfasst, wobei die Steuereinheit eingerichtet ist, Zustandsgrößen des elektrischen Energiespeichers zu erfassen, hat demgegenüber den Vorteil, dass von der Steuereinheit erfasste Zustandsgrößen an eine Recheneinheit außerhalb des elektrischen Energiespeichers übertragen werden, und dass ein Betrieb des elektrischen Energiespeichers auf Basis von Betriebsparametern erfolgt, die von der Recheneinheit bereitgestellt werden. Das Bereitstellen von Betriebsparametern durch die Recheneinheit hat insbesondere den Vorteil, dass die Steuereinheit des elektrischen Energiespeichers weniger Rechenleistung zur Verfügung stellen muss, somit beispielsweise ein im Vergleich zum Stand der Technik günstigerer Mikrocontroller in der Steuereinheit verwendet werden kann.

Vorteilhaft ist, dass die von der Recheneinheit bereitgestellten Betriebsparameter unter Verwendung der von der Steuereinheit erfassten Zustandsgrößen bestimmt werden. Mit anderen Worten kann somit vorteilhafter Weise die Bestimmung der Betriebsparameter von der Steuereinheit an die Recheneinheit ausgelagert werden.

Vorteilhaft ist, dass die Betriebsparameter unter Verwendung von Modellen ermittelt werden, wobei die Modelle geeignet sind, aus den erfassten Zustandsgrößen des elektrischen Energiespeichers Schätzzustandsgrößen des elektrischen Energiespeichers zu ermitteln und die Betriebsparameter ausgehend von den Schätzzustandgrößen ermittelt werden. Unter Zustandsgrößen sind dabei insbesondere solche physikalischen Größen zu verstehen, die mittels einer geeigneten Sensorik in oder an dem elektrischen Energiespeicher erfasst werden können, wie beispielsweise eine Temperatur, ein Strom, eine Spannung oder eine elektrische Ladung. Schätzzustandsgrößen sind solche physikalischen Größen, die ebenfalls den Zustand des elektrischen Energiespeichers beschreiben, allerdings nicht mittels einer Sensorik direkt am elektrischen Energiespeicher erfasst wurden, sondern ausgehend von den erfassten Zustandsgrößen abgeschätzt wurden. Betriebsparameter sind insbesondere physikalische Größen, die als Eingangsgröße für den Betrieb des elektrischen Energiespeichers verwendet werden, beispielsweise der Innenwiderstand des elektrischen Energiespeichers. In einer vorteilhaften Ausgestaltung sind die Betriebsparameter selbst Schätzzustandsgrößen.

Vorteilhaft ist, dass die von der Recheneinheit bereitgestellten Betriebsparameter mittels neuronaler Netze ermittelt werden. Somit ist es insbesondere möglich, die Betriebsparameter bzw. Schätzzustandsgrößen mit einer hohen Genauigkeit zu ermitteln und dabei die üblicherweise durch die Recheneinheit, bei der es sich beispielsweise um eine Cloud handeln kann, bereitgestellte Rechenleistung vorteilhaft auszunutzen.

Vorteilhaft ist, dass sich der elektrische Energiespeicher in einem Fahrzeug befindet und eine Verbindung zwischen der Steuereinheit und der Cloud über ein Drahtloskommunikationsmodul erfolgt. Bei dem Drahtloskommunikationsmodul kann es sich dabei insbesondere um ein Modem, beispielsweise ein GSM-Modem, handeln.

Vorteilhaft ist, dass die Steuereinheit Werte der durch die Cloud bereitgestellten Betriebsparameter speichert und solange zum Betrieb des elektrischen Energiespeichers verwendet, bis aktualisierte Werte der Betriebsparameter von der Cloud verfügbar sind. Üblicherweise ändern sich die Betriebsparameter zum Betreiben des elektrischen Energiespeichers auf langsamen Zeitskalen, insbesondere dann, wenn es sich bei den Betriebsparametern um Schätzzustandsgrößen oder unmittelbar aus den Schätzzustandsgrößen abgeleitete Größen handelt. Somit ist es nicht erforderlich, auf kurzen Zeitskalen, die zum Betrieb des elektrischen Energiespeichers verwendeten Betriebsparameter zu aktualisieren. Durch das Speichern der aktuell verwendeten Betriebsparameter kann somit vorteilhafter Weise ein Datenverkehr zwischen dem Drahtloskommunikationsmodul und der Cloud reduziert werden. Besonders vorteilhaft ist, dass auf diese Weise auch eine erhöhte Robustheit gegenüber einer Unterbrechung der Verbindung zwischen Drahtloskommunikationsmodul und der Cloud sichergestellt werden kann.

Vorteilhaft ist eine Vorrichtung, die eingerichtet ist, jeden Schritt des erfindungsgemäßen Verfahrens durchzuführen. Vorteilhaft ist außerdem ein Computerprogramm, das eingerichtet ist, jeden Schritt des erfindungsgemäßen Verfahrens durchzuführen, wenn das Computerprogramm auf einer Recheneinheit abläuft.

Vorteilhaft sind außerdem ein elektrischer Energiespeicher, der die erfindungsgemäße Vorrichtung umfasst sowie ein Fahrzeug, das die erfindungsgemäße Vorrichtung umfasst.

Nachfolgend wird ein Ausführungsbeispiel der Erfindung näher vorgestellt. Dabei zeigen:
Kurze Beschreibung der Zeichnung
- Figur 1: eine schematische Darstellung eines Fahrzeugs mit einem Elektrischen Energiespeicher;
- Figur 2: eine schematische Darstellung des Ablaufs eines Ausführungsbeispiels des erfindungsgemäßen Verfahrens.

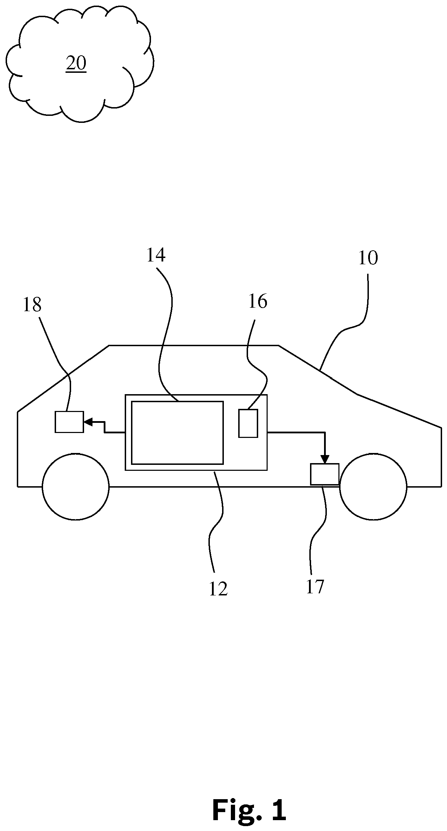

Figur 1 zeigt eine schematische Darstellung eines Fahrzeugs (10), das einen elektrischen Energiespeicher (12), ein Drahtloskommunikationsmodul (18) sowie einen Elektromotor (17) umfasst. Der elektrische Energiespeicher (12) stellt elektrische Energie zum Betreiben des Elektromotors (17) bereit. Der elektrische Energiespeicher (12) steht über eine Signalleitung mit dem Drahtloskommunikationsmodul (18) in Verbindung. Der elektrische Energiespeicher (12) umfasst eine Speicherzelle (14) sowie eine Steuereinheit (16), bei der es sich insbesondere um ein Batteriemanagementsystem (BMS) handeln kann. Das Drahtloskommunikationsmodul (18) ist eingerichtet, eine Verbindung mit einer Cloud (20), die eine Recheneinheit darstellt, herzustellen. In alternativer Ausgestaltung erfolgt die Kommunikation zwischen elektrischem Energiespeicher (12) und Drahtloskommunikationsmodul (18) nicht direkt, sondern über eine in Figur 1 nicht dargestellte Fahrzeugsteuereinheit, beispielsweise eine Vehicle-Control-Unit (VCU).

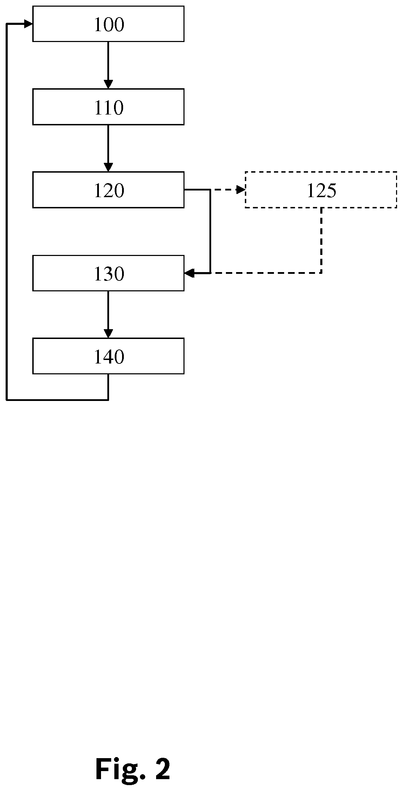

Figur 2 zeigt einen schematischen Ablauf eines Ausführungsbeispiels des erfindungsgemäßen Verfahrens. Das Ausführungsbeispiel startet in Schritt 100. Anschließend folgt Schritt 110.

In Schritt 110 erfasst die Steuereinheit (16) Zustandsgrößen des elektrischen Energiespeichers (12). Bei den erfassten Zustandsgrößen kann es sich insbesondere um eine Temperatur, eine Spannung, einen Strom und/oder eine Ladung handeln. Im Anschluss an Schritt 110 folgt Schritt 120.

In Schritt 120 werden die in Schritt 110 erfassten Zustandsgrößen mittels des Drahtloskommunikationsmoduls (18) an die Cloud (20) übertragen. Im Anschluss an Schritt 120 folgt Schritt 130.

In Schritt 130 werden mittels des Drahtloskommunikationsmoduls (18) Betriebsparameter empfangen, wobei die Betriebsparameter ausgehend von den in Schritt 110 erfassten und in Schritt 120 übertragenen Zustandsgrößen bestimmt wurden. Im Anschluss an Schritt 130 folgt Schritt 140.

Im Schritt 140 wird der elektrische Energiespeicher (12) unter Verwendung der im Schritt 130 empfangenen Betriebsparameter betrieben. Im Anschluss an Schritt 140 folgt erneut Schritt 100, wobei zwischen Schritt 140 und einer erneuten Durchführung von Schritt 100 eine Verzögerung von einer vorgebbaren Zeitdauer vorgesehen sein kann.

Zwischen Schritt 120 und Schritt 130 kann optional Schritt 125 stattfinden. In Schritt 125 werden ausgehend von den übertragenen Zustandsgrößen die Betriebsparameter durch die Cloud (20) abgeschätzt. Hierfür ist es möglich, dass die Cloud (20) die in Schritt 120 übertragenen Zustandsgrößen als Eingangsgrößen für ein Modell verwendet, das geeignet ist, aus den gemessenen Zustandsgrößen Schätzzustandsgrößen des elektrischen Energiespeichers abzuschätzen, d. h. ausgehend von den erfassten Zustandsgrößen wird beispielsweise der physikalische Gesamtzustand des elektrischen Energiespeichers hergeleitet. Ausgehend von den Schätzzustandsgrößen kann unter Verwendung weiterer Modelle oder beispielsweise auch unter Verwendung neuronaler Netze ein Betriebsparameter, bei dem es sich insbesondere auch um eine Schätzzustandsgröße handeln kann, bestimmt werden. Betriebsparameter können dabei alle physikalischen Größen sein, die Eingang in einen Betrieb des elektrischen Energiespeichers (12) finden. Beispielsweise kann es sich bei einem Betriebsparameter um den Innenwiderstand des elektrischen Energiespeichers (12) handeln.

Durch das vorgestellte Ausführungsbeispiel des erfindungsgemäßen Verfahrens ist es möglich, den elektrischen Energiespeicher (12) effizienter zu betrieben, da eine genauere Kenntnis über die zum Betrieb des elektrischen Energiespeichers (12) benötigten Betriebsparameter erhalten werden kann als dass dies durch eine Abschätzung durch die Steuereinheit (16) möglich wäre. Das vorgestellte Ausführungsbeispiel des erfindungsgemäßen Verfahrens lässt sich beispielsweise zur Optimierung einer Rekuperation, eines Schnellladevorgangs, einer Reichweitenstrategie des Fahrzeugs (10) oder einer Vorhersage einer Restlebensdauer des elektrischen Energiespeichers (12) verwenden.

## Patentansprüche

1. Verfahren zum Betreiben eines elektrischen Energiespeichers (12), der eine Speicherzelle (14) zum Speichern von elektrischer Energie und eine Steuereinheit (16) umfasst, wobei die Steuereinheit (16) eingerichtet ist, Zustandsgrößen des elektrischen Energiespeichers (12) zu erfassen, wobei von der Steuereinheit (16) erfasste Zustandsgrößen an eine Recheneinheit außerhalb des elektrischen Energiespeichers (12) übertragen werden, und dass ein Betrieb des elektrischen Energiespeichers (12) auf Basis von Betriebsparametern erfolgt, die von der Recheneinheit bereitgestellt werden , **dadurch gekennzeichnet dass** es sich bei der Recheneinheit um eine Cloud (20) handelt und sich der elektrische Energiespeicher (12) in einem Fahrzeug (10) befindet und eine Verbindung zwischen der Steuereinheit (16) und der Cloud (20) über ein Drahtloskommunikationsmodul (18) erfolgt, wobei die Steuereinheit (16) Werte der durch die Cloud (20) bereitgestellten Betriebsparameter speichert und solange zum Betrieb des elektrischen Energiespeichers (12) verwendet, bis aktualisierte Werte der Betriebsparameter von der Cloud (20) verfügbar sind.

2. Verfahren nach Anspruch 1, **dadurch gekennzeichnet, dass** die von der Recheneinheit bereitgestellten Betriebsparameter unter Verwendung der von der Steuereinheit (16) erfassten Zustandsgrößen bestimmt werden.

3. Verfahren nach Anspruch 2, **dadurch gekennzeichnet, dass** die Betriebsparameter unter Verwendung von Modellen ermittelt werden, wobei die Modelle geeignet sind, aus den erfassten Zustandsgrößen des elektrischen Energiespeichers (12) Schätzzustandsgrößen des elektrischen Energiespeichers (12) zu ermitteln und die Betriebsparameter ausgehend von den Schätzzustandsgrößen ermittelt werden.

4. Verfahren nach Anspruch 2 oder 3, **dadurch gekennzeichnet, dass** die von der Recheneinheit bereitgestellten Betriebsparameter mittels neuronaler Netze ermittelt werden.

5. Vorrichtung, eingerichtet jeden Schritt des Verfahrens nach einem der Ansprüche 1 bis 4 durchzuführen.

6. Computerprogramm, das eingerichtet ist, jeden Schritt des Verfahrens nach einem der Ansprüche 1 bis 4 durchzuführen, wenn das Computerprogramm auf einer Recheneinheit abläuft.

7. Elektrischer Energiespeicher (12), der die Vorrichtung nach Anspruch 6 umfasst.

8. Fahrzeug (10), dass die Vorrichtung nach Anspruch 5 umfasst.

## Claims

1. Method for operating an electrical energy store (12) which comprises a storage cell (14) for storing electrical energy and a control unit (16), wherein the control unit (16) is configured to measure state variables of the electrical energy store (12), wherein state variables measured by the control unit (16) are transmitted to a computing unit outside of the electrical energy store (12), and in that the electrical energy store (12) is operated on the basis of operating parameters provided by the computing unit, **characterized in that** the computing unit is a cloud (20) and the electrical energy store (12) is located in a vehicle (10), and the control unit (16) is connected to the cloud (20) via a wireless communication module (18), wherein the control unit (16) stores values of the operating parameters provided by the cloud (20) and uses them for operating the electrical energy store (12) until updated values of the operating parameters are available from the cloud (20).

2. Method according to Claim 1, **characterized in that** the operating parameters provided by the computing unit are determined using the state variables measured by the control unit (16).

3. Method according to Claim 2, **characterized in that** the operating parameters are ascertained using models, wherein the models are suitable for ascertaining estimated state variables of the electrical energy store (12) from the measured state variables of the electrical energy store (12), and the estimated state variables are used as a basis for ascertaining the operating parameters.

4. Method according to Claim 2 or 3, **characterized in that** the operating parameters provided by the computing unit are ascertained by means of neural networks.

5. Apparatus configured to carry out each step of the method according to one of Claims 1 to 4.

6. Computer program which is configured to carry out each step of the method according to one of Claims 1 to 4 when the computer program runs on a computing unit.

7. Electrical energy store (12) which comprises the apparatus according to Claim 6.

8. Vehicle (10) which comprises the apparatus according to Claim 5.

## Revendications

1. Procédé permettant de faire fonctionner un accumulateur d'énergie électrique (12) qui comprend une cellule d'accumulation (14) pour accumuler de l'énergie électrique et une unité de commande (16), l'unité de commande (16) étant conçue pour acquérir des grandeurs d'état de l'accumulateur d'énergie électrique (12), dans lequel les grandeurs d'état acquises par l'unité de commande (16) sont transmises à une unité de calcul à l'extérieur de l'accumulateur d'énergie électrique (12), et en ce qu'un fonctionnement de l'accumulateur d'énergie électrique (12) est effectué sur la base de paramètres de fonctionnement qui sont fournis par l'unité de calcul,
**caractérisé en ce que** l'unité de calcul est un cloud (20) et l'accumulateur d'énergie électrique (12) se trouve dans un véhicule (10) et une connexion entre l'unité de commande (16) et le cloud (20) est effectuée par l'intermédiaire d'un module de communication sans fil (18), dans lequel l'unité de commande (16) stocke les valeurs des paramètres de fonctionnement fournis par le cloud (20) et les utilise pour faire fonctionner l'accumulateur d'énergie électrique (12) jusqu'à ce que les valeurs mises à jour des paramètres de fonctionnement du cloud (20) soient disponibles.

2. Procédé selon la revendication 1, **caractérisé en ce que** les paramètres de fonctionnement fournis par l'unité de calcul sont déterminés en utilisant les grandeurs d'état acquises par l'unité de commande (16).

3. Procédé selon la revendication 2, **caractérisé en ce que** les paramètres de fonctionnement sont établis en utilisant des modèles, les modèles étant adaptés pour établir à partir des grandeurs d'état acquises de l'accumulateur d'énergie électrique (12) des grandeurs d'état d'estimation de l'accumulateur d'énergie électrique (12), et les paramètres de fonctionnement sont établis en partant des grandeurs d'état d'estimation.

4. Procédé selon la revendication 2 ou 3, **caractérisé en ce que** les paramètres de fonctionnement fournis par l'unité de calcul sont établis au moyen de réseaux neuronaux.

5. Dispositif, conçu pour effectuer chaque étape du procédé selon l'une quelconque des revendications 1 à 4 .

6. Programme informatique qui est conçu pour effectuer chaque étape du procédé selon l'une quelconque des revendications 1 à 4 lorsque le programme informatique est exécuté sur une unité de calcul.

7. Accumulateur d'énergie électrique (12) qui comprend le dispositif selon la revendication 6.

8. Véhicule (10) comprenant le dispositif selon la revendication 5.
